# DEMANDE DE BREVET EUROPEEN

(11) **EP 4 571 825 A1**
(43) Date de publication de la demande: **18.06.2025**
(21) Numéro de dépôt: 24213784.2
(22) Date de dépôt: 19.11.2024
(51) Int. Cl.: H01L 23/00, H01L 21/683, H01L 23/31

(54) **PROCEDE DE FABRICATION DE COMPOSANTS ELECTRONIQUES A FLANCS MOUILLABLES**

(30) Priorité: 23.11.2023 FR 2312922
(71) Demandeur: STMicroelectronics International N.V., 1228 Plan-les-Ouates, Geneva (CH)
(72) Inventeur: FALLOURD, Ludovic, 37320 LOUANS (FR)
(74) Mandataire: Cabinet Beaumont

(57) **Abrégé**

Procédé de fabrication de composants électroniques à flancs mouillables à partir d'un substrat (301) recouvert par des plages de connexion (107) et dans lequel sont formées des puces (103), le procédé comprenant les étapes suivantes :
a) braser des plots de connexion sur les plages de connexion (107),
b) enrober les plots de connexion par une couche de résine isolante (121),
c) amincir la couche de résine isolante (121) jusqu'à atteindre les plots de connexion,
d) former des cavités en retirant une partie des plots de connexion et une partie de la couche de résine isolante (121), de manière à rendre accessible une partie des flancs des composants,
e) déposer une couche de matériau conducteur (122) sur les flancs des composants et sur les plots de connexion,
f) séparer les puces (103).

## Description

### Domaine technique

La présente description concerne la fabrication de composants électroniques. Elle vise plus particulièrement la fabrication de composants dits à montage en surface, c'est-à-dire comportant, du côté d'au moins une face, une ou plusieurs métallisations de connexion destinées à être brasées à des plages de connexion correspondantes d'un dispositif externe, par exemple une carte de circuit imprimé ou un autre composant.

### Technique antérieure

Dans certaines applications, il existe un besoin pour des composants à montage en surface dans lesquels des métallisations de connexion destinées à être brasées à un dispositif externe s'étendent jusqu'aux flancs des composants. On parle de composants à flancs mouillables (en anglais "wettable flank"). Lors du montage du composant dans son environnement (par exemple, sur une carte de circuit imprimé), les métallisations de connexion (aussi appelées contacts électriques) sont soudées ou brasées à des pistes ou éléments métalliques correspondants côté circuit imprimé. Une partie du matériau de brasage remonte alors sur les flancs des composants, ce qui permet de mettre en oeuvre une inspection visuelle de la qualité des connexions.

Ce besoin existe par exemple dans le domaine automobile ou le domaine médical et, plus généralement, dans les domaines où l'on souhaite garantir la fiabilité des connexions électriques, une fois les circuits montés dans leur environnement.

### Résumé de l'invention

Il existe un besoin d'améliorer au moins en partie certains aspects des procédés connus de fabrication de composants électroniques à flancs mouillables.

Ce but est atteint par un procédé de fabrication de composants électroniques à flancs mouillables à partir d'un substrat recouvert par des plages de connexion et dans lequel sont formées des puces, le procédé comprenant les étapes suivantes :
a) braser des plots de connexion sur les plages de connexion des puces,
b) enrober les plots de connexion par une couche de résine isolante,
c) amincir la couche de résine isolante jusqu'à atteindre les plots de connexion,
d) former des cavités en retirant une partie des plots de connexion et une partie de la couche de résine isolante, de manière à rendre accessible une partie des flancs des composants,
e) déposer une couche de matériau conducteur sur les flancs des composants et sur les plots de connexion,
f) séparer les puces au niveau des cavités.

Selon un mode de réalisation, les plots de connexion comprennent un coeur électriquement conducteur, recouvert par une couche de matériau brasable.

Selon un mode de réalisation, le matériau brasable est Sn ou un alliage d'étain tel que SnAg ou SnAgCu.

Selon un mode de réalisation le coeur électriquement conducteur est en cuivre.

Selon un mode de réalisation, le matériau conducteur et le matériau brasable sont identiques.

Selon un mode de réalisation, l'étape e) est réalisée par impression.

Ce but est également atteint par un composant électronique à flancs mouillables comprenant une puce ayant des pages de connexion protégée par un boîtier comprenant une première face principale, des flancs et une deuxième face principale, une couche de matériau conducteur recouvrant une partie des flancs et s'étendant sur la première face principale, la couche de matériau conducteur étant connectée électriquement aux plages de connexion électrique de la puce au moyen de plots de connexion brasés sur les plages de connexion.

Selon un mode de réalisation, les plots de connexion comprennent un coeur électriquement conducteur recouvert au moins partiellement par une couche de matériau brasé sur les plages de connexion.

Selon un mode de réalisation, la couche de matériau conducteur est Sn ou en un alliage d'étain, tel que SnAg ou SnAgCu.

Selon un mode réalisation, une couche de résine isolante recouvre la première face principale de la puce entre les plots de connexion.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et en coupe, un composant électronique à flancs mouillables selon un mode de réalisation particulier ;
la figure 2A, la figure 2B, la figure 2C, la figure 2D, la figure 2E et la figure 2F représentent des vues en coupe illustrant des étapes d'un procédé de fabrication d'un composant électronique à flanc mouillable selon un mode de réalisation particulier ;
la figure 3 représente un composant électronique à flanc mouillable, en vue de dessus, obtenu par le procédé des figures 2A à 2F ;
la figure 4A et la figure 4B représentent des vues en coupe illustrant des étapes d'un procédé de fabrication d'un composant électronique à flanc mouillable selon un autre mode de réalisation particulier ;
la figure 5 représente un composant électronique à flanc mouillable, en vue de dessus, obtenu par le procédé des figures 4A et 4B ;
la figure 6 est un cliché obtenu au microscope électronique à balayage (MEB) représentant un plot de connexion sphérique à structure coeur-coquille selon un mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un ... dans une position normale d'utilisation.

Sauf précision contraire, les expressions "environ", "approximativement", "sensiblement", et "de l'ordre de" signifient à 10 % près, de préférence à 5 % près.

Les composants électroniques trouvent des applications dans de nombreux domaines industriels, et en particulier, dans le domaine automobile ou le domaine médical.

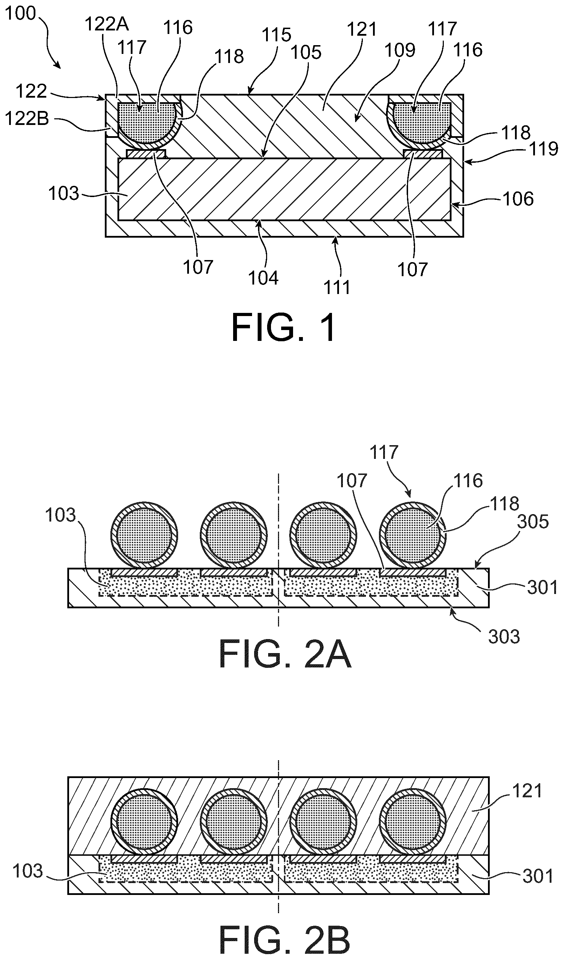

La figure 1 illustre, par une vue en coupe, partielle et schématique, un composant électronique 100.

Le composant électronique 100 est formé d'une puce électronique 103 et d'un boîtier 109. Selon un exemple, la puce électronique 103 est formée à partir d'un substrat semiconducteur, par exemple en silicium. Il peut également s'agir de SiC. Alternativement, le substrat peut être du verre ou du saphir.

La puce comprend une face avant 105 (aussi appelée première face ou face avant), une face arrière 104 (aussi appelée deuxième face ou face arrière) et des flancs 106 (aussi appelés faces latérales). La face inférieure 104 est opposée à la face supérieure 105.

Une ou plusieurs plages de connexion 107 (aussi appelés contacts électriques) sont formées sur la face supérieure 105 de la puce électronique 103 et permettent de la connecter à d'autres éléments (puces ou dispositifs électroniques).

Les plages de connexion électriques 107 sont aussi appelés « UBM » (pour l'expression anglo-saxonne « Under Bump Metallization »). Les plages de connexion électriques 107 sont en un matériau conducteur spécifiquement adapté à recevoir les plots de connexion 117, et présentant notamment une bonne adhérence avec les plots 177. Les plages de connexion électriques 107 comprennent au moins un des éléments suivants : or, titane, nickel, cuivre, argent, étain ou tungstène. De préférence, elles comprennent de l'or ou du cuivre. Les plages de connexion 107 peuvent être recouvertes d'une couche métallique (« plating »).

Les plages de connexion électrique 107 sont, par exemple, à une distance de 10 à 50 µm, voire de 10 à 30 µm de la paroi latérale de la puce. La distance va dépendre de la taille des plots de connexion 117. Les plages de connexion électrique 107 peuvent être positionnées sur la face supérieure 105 de la puce 103 ou affleurer la face supérieure (i.e. arriver au niveau de la face supérieure 105 de la puce 103) .

La puce 103 peut comprendre un composant discret ou plusieurs composants discrets. Le ou les composants discrets sont, par exemple, choisis parmi les transistors, diodes, thyristors, triacs, filtres, etc. La puce 103 peut comprendre un ou plusieurs circuits électroniques. La puce 103 permet de mettre en oeuvre différentes fonctions électroniques.

Le composant 100 est un composant dit intégré.

La puce 103 est protégée par le boîtier 109. Plus particulièrement, le boîtier 109 recouvre au moins la face supérieure 105. De préférence, comme représenté sur la figure 1, il peut également recouvrir les flancs 106 de la puce 103 et/ou la face inférieure 105 de la puce 103.

Le boitier 109 est en un matériau isolant électriquement.

Pour pouvoir connecter le composant 100 à d'autres composants et/ou circuits électroniques, le boîtier 109 comprend, en outre, des plots de connexion 117 (aussi appelés contacts du boîtier ou reprises de contacts). Les plots de connexion 117 sont positionnés sur la face supérieure 105 de la puce 103. Chaque plot de connexion 117 est relié à une plage de connexion électriques 107 de la puce 103.

Les plots de connexion 117 peuvent être des éléments métalliques.

Les plots de connexion 117 sont, par exemple, des billes métalliques. Il peut s'agir de billes en cuivre, en nickel ou en tout autre matériau non fusible.

Les plots de connexion 117 peuvent être des éléments comprenant un coeur 118 électriquement conducteur recouvert par une couche 116 (aussi appelée coquille) en matériau brasable.

De préférence, le coeur 118 électriquement conducteur est en cuivre.

De préférence, le matériau brasable est de l'étain ou un de ses alliages, comme SnAgCu ou SnAg. La couche 116 joue le rôle de couche barrière à l'oxydation.

Les plages de connexion électriques 107 de la puce 103 et les plots de connexion 117 sont positionnés dans des ouvertures d'une couche de résine isolante 121 recouvrant la puce 103.

Le composant 100 est un composant à flanc mouillable, c'est-à-dire qu'au moins une partie de ses flancs est recouverte par une couche en un matériau mouillable et/ou soudable, c'est-à-dire un matériau sur lequel il est possible de braser ou de réaliser une autre méthode de fixation mécanique (colle conductrice, frittage par exemple).

La couche 122 de matériau mouillable recouvre une partie des flancs 119 du composant 100 et s'étend sur la première face principale 115 du composant 100. Cette couche forme une couche continue dont une première partie 122A recouvre une partie de la première face 115 du composant 100 et dont une deuxième partie 122B recouvre une partie des flancs 119 du composant 100.

Le matériau mouillable est en contact direct avec les plots de connexion 117. Par contact direct, on entend qu'il n'y a pas d'élément entre les plots de connexion 117 et le matériau mouillable. Il est en contact direct au niveau des flancs 119 et au niveau de la première face principale 115.

Le matériau mouillable est, de préférence, un matériau pouvant être brasé, tel que Sn, SnAg ou SnAgCu, ou un autre matériau à plus haut point de fusion.

Nous allons maintenant décrire plus en détail le procédé de fabrication d'un tel composant 100 en faisant référence aux figures 2A à 2F.

Le procédé est réalisé à partir d'un substrat 301 recouvert par des plages de connexion 107 et dans lequel sont formées des puces 103.

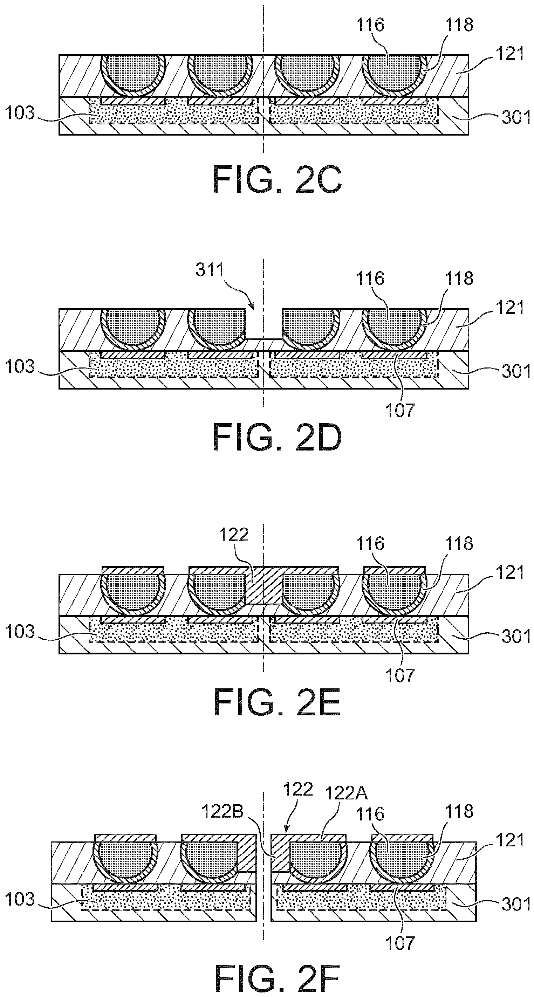

Le procédé comporte les étapes suivantes :
a) braser des plots de connexion 117 sur les plages de connexion 107, les plots de connexion 117 comprenant, de préférence, un coeur électriquement conducteur 118, recouvert par une couche de revêtement 116 en un matériau brasable (figure 2A),
b) déposer une couche de résine isolante 121 sur le substrat 301, la couche de résine isolante 121 enrobant les plots de connexion 117 et les plages de connexion 107(figure 2B),
c) amincir la couche de résine isolante 121 jusqu'à atteindre les plots de connexion 117, et le cas échéant, le coeur 118 des plots de connexion 117 (figure 2C),
d) former des cavités 311 entre les puces 103 en retirant localement une partie des plots de connexion 117 et une partie de la couche de résine isolante 121, de manière à rendre accessible une partie des flancs 119 des composants 100 (figure 2D),
e) déposer une couche de matériau conducteur 122 sur les flancs 119 des composants 100 et sur les plots de connexion (figure 2E),
f) séparer les puces 103 en découpant dans les cavités 311 (figure 2F), moyennant quoi on obtient des composants 100 à flancs mouillables.

A l'étape a), la fabrication du ou des composants discrets et/ou circuits intégrés formant les composants 100 est achevée. Les composants 100 sont formés à partir d'un même substrat 301, et n'ont pas encore été individualisées. Les puces 103 sont délimitées par un trait pointillé dans le substrat 301. Le substrat 301 comprend une première face 305 (face supérieure ou face avant) et une deuxième face 303 (ou face arrière). Les puces adjacentes 103 sont séparées les unes des autres par une partie du substrat 301. Autrement dit, la partie du substrat 301 sépare les puces adjacentes 103.

Le substrat 301 est, par exemple, un substrat semiconducteur, par exemple en silicium, ou en SiC.

Le substrat 301 a, par exemple, une épaisseur comprise entre 300 et 900 µm, par exemple une épaisseur d'environ 725 µm.

De plus, des plages de connexion électriques 107, décrits en relation avec la figure 1, ont été formés sur une face supérieure 305 du substrat 301 (figure 2A).

Lors de l'étape a), les plots de connexion 117 sont brasés sur les plages de connexion 107.

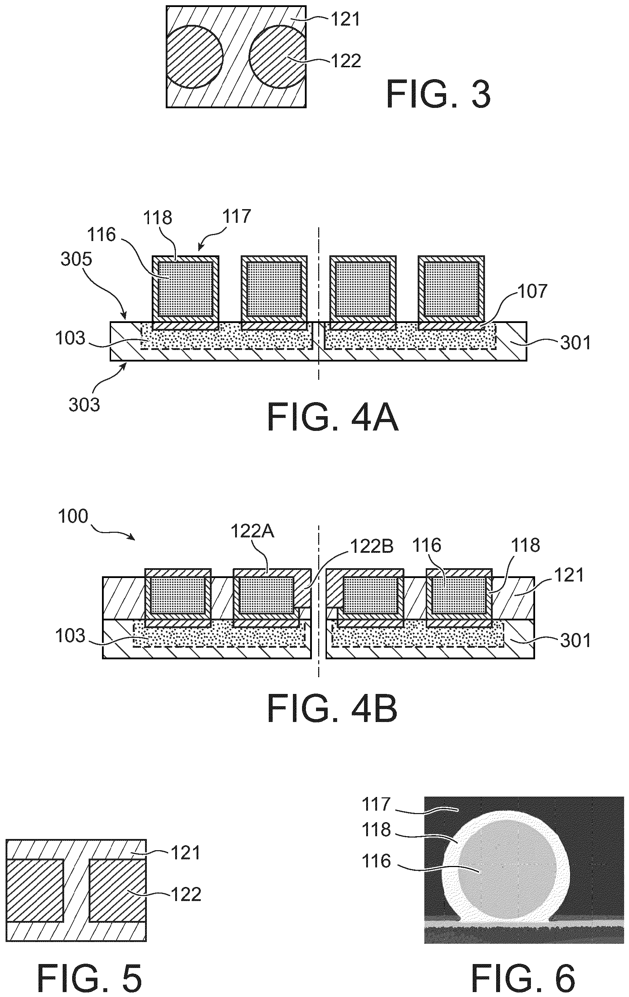

Comme représenté sur les figures 2A à 2F et 3, les plots de connexion 117 peuvent être des billes (i.e. de formes sphériques). Il est évident que les dessins sont des représentations schématiques et que, en réalité, les plots de connexion 117 et les plages de connexion 107 ont une surface de contact plus grande qu'un simple point de contact lorsqu'ils sont soudés l'un à l'autre.

Alternativement, comme représenté sur les figures 4A, 4B et 5, les plots de connexion peuvent être des colonnes. Il peut s'agir de piliers de section carrée, circulaire ou rectangulaire.

De préférence, les plots de connexion 117 comprennent un coeur 116 en un premier matériau et une coquille (ou revêtement) 118 en un deuxième matériau.

La coquille 118 recouvre, de préférence, continument le coeur. La coquille a, par exemple, une épaisseur comprise entre 10 et 20pm.

Le coeur 116 électriquement conducteur est, de préférence, en cuivre.

La coquille 118 ou revêtement est en un matériau pouvant être brasé sur les plages de connexion. En particulier, il s'agit d'étain ou d'un alliage d'étain, tel que SnAg ou SnAgCu.

La figure 6 représente, à titre illustratif et non limitatif, un cliché MEB d'un plot de connexion 117 sphérique ayant un coeur en cuivre et une coquille en un alliage à base d'étain.

Sur une variante non représentée, les plots de connexion sont des billes métalliques. Les billes ne sont pas recouvertes par une coquille. Il peut s'agir de billes en cuivre, en nickel.

Lors de l'étape b), une couche de résine isolante 121 est déposée sur le substrat 301.

Plus particulièrement, la couche de résine isolante 121 est déposée sur la première face 305 du substrat 301 et sur les plots 117. Ainsi, les plots 117 sont disposés au sein de la résine. La couche de résine isolante 121 forme une première partie du boîtier des composants 100. A titre d'exemple, la couche 121 peut être déposée par sérigraphie, par compression ou par injection. Cette première partie du boîtier protège donc la face supérieure des composants 100.

La résine est une résine isolante électriquement. Plus particulièrement, la résine comporte au moins un matériau de base auquel des particules isolantes électriquement sont ajoutés. Le matériau de base est choisi parmi le groupe comprenant : les résines de type époxy, et les résines de type phénolique, les résines de type acrylique. De préférence, il s'agit d'une résine de type époxy. Les particules sont, par exemple, des particules d'oxyde, et notamment des particules d'alumine ou de silice.

La polymérisation est, par exemple, réalisée sous rayonnement ultra-violet (UV) ou par activation thermique. Un recuit peut être réalisé avant l'étape c).

Lors de l'étape c), une étape d'amincissement est réalisée depuis la face avant afin de retirer la partie de la résine isolante 121 recouvrant les plots de connexion 117 et la partie supérieure des plots connexion 117 jusqu'à atteindre le coeur 116 des plots de connexion 117.

L'étape d'amincissement en face avant peut être réalisée par polissage ('grinding'). Un polissage de type mécanique est, de préférence, choisi.

Lors de l'étape d), les cavités 311 sont formées entre les puces 103 afin de retirer une partie de la couche de résine 121 et une partie des plots de connexion 117. Le coeur 116 des plots de connexion 117 est ainsi également accessible latéralement.

Les cavités 311 obtenues s'étendent depuis la face avant et sur une profondeur correspondant au minimum à la hauteur de la couche de matériau conducteur 122 recouvrant les flancs des composants 100 décrites ci-après. La hauteur de la cavité 311 est inférieure à l'épaisseur de la couche de résine isolante 121 afin d'isoler les flancs mouillables du substrat 301.

L'étape d) est réalisée au moyen d'un dispositif de découpe. Le dispositif de découpe est, par exemple, un outil de découpe mécanique comme une scie, ou un outil de gravure par un laser. Selon un mode de réalisation préféré, le dispositif de découpe est un laser. De plus, lorsque le dispositif de découpe est un laser, la technique de découpe utilisée peut être une technique de type structuration directe par laser (LDS, « Laser Direct Structuring »).

Lors de l'étape e), une couche 122 de matériau conducteur est déposée de manière à recouvrir au moins une partie des flancs 119 des composants 100 et les plots de connexion 117.

La couche 122 de matériau conducteur peut être déposée par une méthode d'impression, une méthode de dépôt additif ou encore par immersion dans un bain. Il est, par exemple, possible de déposer un matériau antioxydant sur les surfaces métalliques. Le dépôt est sélectif.

La couche 122 de matériau conducteur est, avantageusement, déposée localement par une technique de type dispense (« dispensing »), et de préférence, par impression (« screen printing »), notamment à travers un masque.

Alternativement, elle peut être déposée pleine plaque.

A l'issue de l'étape e), les cavités 311 sont remplies par le matériau conducteur et le coeur 116 des plots de connexion 117 est recouvert par la couche 122 de matériau conducteur. Le coeur 116 est ainsi recouvert totalement par une couche de protection formée en partie de la coquille 118 et en partie de la couche 122. Le coeur est ainsi protégé de l'environnement extérieur, et notamment de l'oxydation, ce qui est particulièrement avantageux dans le cas d'un coeur 116 en cuivre.

Lors de l'étape f), les composants 100 sont individualisés en réalisant une découpe au niveau des cavités 311. Les composants 100 sont ainsi séparés les uns des autres. Dans certains cas, l'étape de découpe consiste aussi à couper la partie du substrat 301 qui sépare les puces adjacentes 103.

Il est également possible de réaliser les étapes dans l'ordre suivant : a), b), c), d), f) et e). Après la formation des cavités 311, il est possible de poursuivre par une découpe totale (étape f)) puis de réaliser le dépôt de la couche de matériau conducteur 122 (étape e)). La couche déposée est, avantageusement, une couche organique. Elle sert aussi de couche de protection à l'oxydation.

Le procédé peut également comprendre une étape d'amincissement en face arrière. Pour cela, la structure est retournée et fixée par sa face avant, c'est-à-dire la face 305, sur un support. Le support est, par exemple, une bande de ruban adhésif. La structure est, ensuite, amincie par sa face arrière 303 de façon que le substrat 301 ait son épaisseur définitive.

Le procédé peut, avantageusement, comprendre une étape au cours de laquelle, une couche isolante additionnelle est déposée sur la face arrière 303 de la structure pour former la face arrière du boîtier 111 et/ou sur les faces latérales 106 de la puce 103.

La couche isolante additionnelle est une couche en un matériau isolant électriquement, par exemple une résine, par exemple une résine du même type que la résine de la couche 121. Selon un autre exemple, les matériaux des couches sont différents.

A l'issue du procédé, les composants 100 obtenus sont des composants à montage en surface (ou SMD pour « surface mouting device ») de type "flip-chip", c'est-à-dire qu'ils peuvent être fixés sur un dispositif externe, par exemple, une carte de circuit imprimé ou un autre composant, par leur face supérieure, c'est-à-dire la face sur laquelle sont disposés les contacts 117 du boîtier 109.

Pour cela, un matériau de brasage est positionné entre le composant 100 et le dispositif externe. Lors du brasage, le matériau de brasage remonte le long des flancs 119 des composants 100, ce qui permet de vérifier que le brasage a été réalisé correctement.

De tels composants 100 sont particulièrement intéressants pour garantir la fiabilité des connexions électriques, une fois les circuits montés dans leur environnement.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication de composants électroniques (100) à flancs mouillables à partir d'un substrat (301) recouvert par des plages de connexion (107) et dans lequel sont formées des puces (103), le procédé comprenant les étapes suivantes :
a) braser des plots de connexion (117) sur les plages de connexion (107) des puces (103),
b) enrober les plots de connexion (117) par une couche de résine isolante (121),
c) amincir la couche de résine isolante (121) jusqu'à atteindre les plots de connexion (117),
d) former des cavités (311) en retirant une partie des plots de connexion (117) et une partie de la couche de résine isolante (121), de manière à rendre accessible une partie des flancs (119) des composants (100),
e) déposer une couche de matériau conducteur (122) sur les flancs (119) des composants (100) et sur les plots de connexion (117),
f) séparer les puces (103) au niveau des cavités (311).

2. Procédé selon la revendication 1, dans lequel les plots de connexion (117) comprennent un coeur électriquement conducteur (116), recouvert par une couche de matériau brasable (118).

3. Procédé selon la revendication précédente, dans lequel le matériau brasable est Sn ou un alliage d'étain tel que SnAg ou SnAgCu.

4. Procédé selon l'une des revendications 2 et 3, dans lequel le coeur électriquement conducteur (116) est en cuivre.

5. Procédé selon l'une quelconque des revendications 2 à 4, dans lequel le matériau conducteur et le matériau brasable sont identiques.

6. Procédé selon l'une quelconque des revendications précédentes, dans lequel l'étape e) est réalisée par impression.

7. Composant électronique (100) à flancs mouillables comprenant une puce (103) ayant des pages de connexion (107) protégée par un boîtier (109) comprenant une première face principale (115), des flancs (119) et une deuxième face principale, une couche de matériau conducteur (122) recouvrant une partie des flancs (119) et s'étendant sur la première face principale (115), la couche de matériau conducteur (122) étant connectée électriquement aux plages de connexion électrique (107) de la puce (103) au moyen de plots de connexion (117) brasés sur les plages de connexion (107) .

8. Composant selon la revendication 7, dans lequel les plots de connexion (117) comprennent un coeur (116) électriquement conducteur recouvert au moins partiellement par une couche de matériau (118) brasé sur les plages de connexion (107).

9. Composant électronique (100) selon la revendication 7 ou 8, dans lequel la couche de matériau conducteur (122) est Sn ou en un alliage d'étain, tel que SnAg ou SnAgCu.

10. Composant électronique selon l'une des revendications 7 à 9, dans lequel une couche de résine isolante (121) recouvre la première face principale (105) de la puce (103) entre les plots de connexion (117).
